# EUROPÄISCHE PATENTSCHRIFT

(11) **EP 2 641 096 B1**
(45) Veröffentlichungstag und Bekanntmachung des Hinweises auf die Patenterteilung: **10.02.2016**
(21) Anmeldenummer: 11784971.1
(22) Anmeldetag: 04.11.2011
(51) Int. Cl.: G01R 21/10

(54) **THERMISCH STABILISIERTER LEISTUNGSSENSOR**
THERMALLY STABILIZED POWER SENSOR
CAPTEUR DE PUISSANCE À STABILISATION THERMIQUE

(30) Priorität: 15.11.2010 DE 102010051432
(43) Veröffentlichungstag der Anmeldung: 25.09.2013
(73) Patentinhaber: Rohde & Schwarz GmbH & Co. KG, 81671 München (DE)
(72) Erfinder: Perndl, Werner, Dr., 85591 Vaterstetten (DE); Bratfisch, Toralf, 85640 Putzbrunn (DE); Katzer, Michael, 80337 München (DE); Reichel, Thomas, 85598 Baldham (DE)
(74) Vertreter: Körfer, Thomas
(86) Internationale Anmeldenummer: PCT/EP2011/069460
(87) Internationale Veröffentlichungsnummer: WO 2012/065866

(56) Entgegenhaltungen:
- EP-A2- 0 852 434
- WO-A1-02/10776
- JP-A- 10 267 970
- US-A- 4 791 380
- US-A- 4 932 075
- US-A- 5 936 537
- US-A- 5 937 059
- RONALD E PRATT: "Very-Low-Level Microwave Power Measurements", HEWLETT-PACKARD JOURNAL,, Bd. 27, Nr. 2, 1. Oktober 1975 (1975-10-01), Seiten 8-10, XP001456497,

## Beschreibung

Die Erfindung betrifft einen Leistungssensor, insbesondere mit einem Diodendetektor.

Herkömmliche Leistungssensoren setzen in einem hermetisch gekapselten Gehäuse auf einem Substrat angeordnete diskrete Detektordioden ein, wobei das Substrat in engem thermischen Kontakt mit dem Gehäuse steht. Aufgrund seiner hohen Masse von z.B. 50g verfügt ein solches metallisches Gehäuse über eine hohe thermische Kapazität. Dies führt zu einer hohen Zeitkonstante bzgl. der Reaktion auf Temperaturveränderungen, wenn man das Gehäuse beheizen wollte. Darüber hinaus wäre große Heizleistung notwendig, um die große Masse zu beheizen.

Temperaturschwankungen führen bei Diodensensoren, wie z.B. in der DE 100 39 665 A1 gezeigt, zu verschiedenen negativen Effekten auf das Messergebnis. So ist zum einen der Nullpunktwiderstand der Dioden temperaturabhängig. Dies führt zu unterschiedlichen Abschlusswiderständen und somit zu unterschiedlichen Reflexions-Koeffizienten. Bei Schottky-Dioden ergibt sich z.B. eine Widerstandsabhängigkeit von -4 %/K. D.h. bei einer Temperaturänderung um 15 K halbiert sich der Nullpunktwiderstand der Detektordiode. Weiterhin ist das Rauschverhalten der Detektordioden ebenfalls temperaturabhängig.

Um Verfälschungen der Messwerte des Diodendetektors auf Grund seiner Temperaturabhängigkeit zu verhindern, werden Kompensationsschaltungen eingesetzt. So zeigt die EP 1 026 822 B1 einen Diodendetektor mit kompensierter Temperaturdrift. Nachteilig hieran ist, dass die Kompensation einerseits nicht sämtliche Restfehler eliminieren kann und andererseits mittels der Kompensation ein durch Temperaturänderungen beeinflusstes Rauschverhalten und Reflexionsverhalten des Detektors nicht kompensiert werden kann.

Das Japanische Patent JP 10 267 970 A zeigt weiterhin einen Leistungsdetektor ausgeführt als integrierte Schaltung. In die integrierte Schaltung integriert ist eine Heizdiode. Das Hochfrequenzsignal wird dabei durch einen Hohlleiter zugeführt. Die integrierte Schaltung befindet sich in einer Unterbrechung des Hohlleiters. Ein Teil der Leistung des Hochfrequenzsignals wird mittels Antennen, welche ebenfalls Teil der integrierten Schaltung sind, empfangen und dem Leistungsdetektor zugeführt. Nachteilig ist hieran, dass sich dieser Aufbau nur für eine Zuführung des Signals mittels eines Hohlleiters eignet.

Der Erfindung liegt die Aufgabe zugrunde, ein Leistungsmessgerät zu schaffen, welches bei geringem Energieverbrauch und geringem Herstellungsaufwand eine sehr hohe Messgenauigkeit ermöglicht.

Die Aufgabe wird erfindungsgemäß durch die Merkmale des unabhängigen Anspruchs 1 gelöst. Vorteilhafte Weiterbildungen sind Gegenstand der hierauf rückbezogenen Unteransprüche.

Das Leistungsmessgerät verfügt über einen Leistungsdetektor und eine Temperierungsvorrichtung. Der Leistungsdetektor ist als integrierte Schaltung auf einem monolithischen Chip integriert. Er setzt ein Hochfrequenz-Messsignal in ein Signal, welches die Leistung des Hochfrequenz-Messsignals anzeigt, um. Das Leistungsmessgerät verfügt weiterhin über einen Signaleingang. Der Signaleingang ist mittels einer ersten Leitung auf einem Kunststoffsubstrat thermisch isolierend mit dem Leistungsdetektor verbunden. Der Signaleingang führt dem Leistungsdetektor das Hochfrequenz-Messsignal mittels der ersten Leitung zu. So wird eine sehr genaue Messung bei geringem Herstellungsaufwand erreicht.

Die Temperierungsvorrichtung ist dabei bevorzugt auf einer der integrierten Schaltung abgewandten Seite des monolithischen Chips angeordnet. Durch die Anordnung der Temperierungsvorrichtung auf der Rückseite ist eine sehr gleichmäßige Temperierung des Leistungsdetektors möglich, da diese Vollflächig erfolgen kann.

Vorteilhafterweise wird die konstante Temperatur durch eine geringe thermische Kopplung des Leistungsdetektors an das übrige Leistungsmessgerät erreicht. So wird lediglich eine geringe Heizleistung benötigt. Außerdem wird so eine geringe Zeitkonstante erreicht. Eine Erwärmung des gesamten Leistungsmessers wird so vermieden.

Die geringe thermische Kapazität wird vorteilhafterweise durch eine geringe Masse und eine geringe spezifische thermische Kapazität des Materials des Leistungsdetektors erreicht. Ein exemplarischer herkömmlicher Leistungsdetektor hat eine Masse von 50g, benötigt eine Heizleistung von 5W und erreicht eine Zeitkonstante von 1-2 Minuten. Ein erfindungsgemäßer Leistungsdetektor hat lediglich eine Masse von ca. 1,5µg, eine Heizleistung von 100mW und eine Zeitkonstante von weniger als einer Sekunde.

Die geringe thermische Kopplung wird bevorzugt durch eine Isolation des Leistungsdetektors gegenüber dem übrigen Leistungsdetektor erreicht. Vorteilhafterweise erfolgt die elektrische Anbindung mittels Koplanarleitungen, Streifenleitungen oder Schlitzleitungen auf bevorzugt flexiblen Kunststoffsubstraten. Es wird so insbesondere eine thermische Entkopplung vom Hochfrequenz-Eingang erreicht. Weil der Innenleiter nicht direkt sondern nur indirekt über die Leitung auf dem Kunststoffsubstrat angekoppelt ist, erfolgt die Zuleitung über eine Koaxialleitung, so ist der Leistungsdetektor so sehr gut thermisch von dem Innenleiter der Koaxialleitung entkoppelt.

Vorteilhafterweise werden Ausgangssignale des Leistungsdetektors weiterhin über weitere Leitungen auf dem Kunststoffsubstrat abgeführt. So wird eine weitere Vereinfachung der Herstellung erreicht.

Das Substrat ist dünn mit einer bevorzugten Dicke von 10 µm - 100 µm.

Nachfolgend wird die Erfindung anhand der Zeichnung, in der ein vorteilhaftes Ausführungsbeispiel der Erfindung dargestellt ist, beispielhaft beschrieben. In der Zeichnung zeigen:
- Fig. 1: ein beispielhaftes Leistungsmessgerät;
- Fig. 2: ein erstes Ausführungsbeispiel des erfindungsgemäßen Leistungsmessgeräts;
- Fig. 3: ein zweites Ausführungsbeispiel des erfindungsgemäßen Leistungsmessgeräts;
- Fig. 4: das zweite Ausführungsbeispiel des erfindungsgemäßen Leistungsmessgeräts in einer alternativen Ansicht;
- Fig. 5: ein drittes Ausführungsbeispiel des erfindungsgemäßen Leistungsmessgeräts, und
- Fig. 6: das dritte Ausführungsbeispiel des erfindungsgemäßen Leistungsmessgeräts in einer alternativen Ansicht.

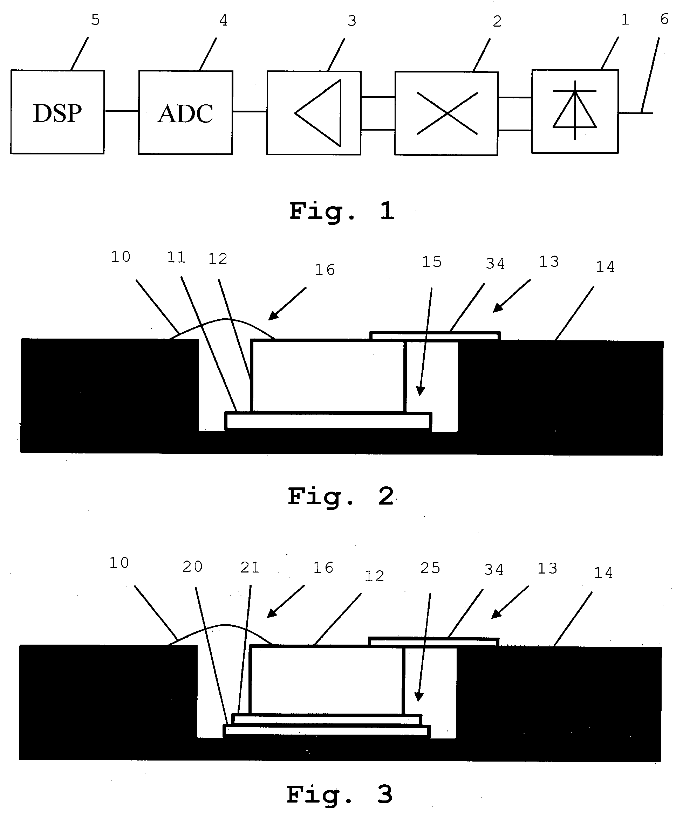

Zunächst werden anhand der Fig. 1 der generelle Aufbau und die Funktionsweise eines beispielhaften Leistungsmessgeräts und die zugrundeliegende Problematik erläutert. Anschließend werden mittels Fig. 2 - 6 der detaillierte Aufbau und die Funktionsweise verschiedener Formen des erfindungsgemäßen Leistungsmessgeräts näher veranschaulicht. Identische Elemente wurden in ähnlichen Abbildungen z.T. nicht wiederholt dargestellt und beschrieben.

Bei herkömmlichen Detektordioden für Leistungssensoren ist es somit notwendig, den Nullpunktwiderstand der Dioden so zu wählen, dass er über dem gesamten Temperaturbereich des Leistungssensors ausreichend hoch gegenüber dem Abschlusswiderstand von z.B. 50Ω ist. Gleichzeitig ist zur Verringerung des Rauschsignals ein möglichst niedriger Nullpunktwiderstand anzustreben. Wird z.B. bei 25°C ein Nullpunktwiderstand von R₀=5kΩ gewählt, ergibt sich bei einem exemplarischen unteren Temperaturgrenzwert von 0°C z.B. ein Widerstand von R₀=15,8kΩ, während sich bei einem exemplarischen oberen Grenzwert der Betriebstemperatur von 50°C z.B. ein Nullpunktwiderstand von R₀=1,58kΩ ergibt. Beide Werte liegen noch deutlich über dem Abschlusswiderstand von 50Ω. Soll der Leistungssensor jedoch bei deutlich höheren Temperaturen eingesetzt werden, erreicht der Nullpunktwiderstand R₀ eine ähnliche Größenordnung wie der Abschlusswiderstand und wirkt somit problematisch. Bei wesentlich tieferen Temperaturen wird der Widerstand so hoch, dass er das Rauschverhalten negativ beeinflusst.

Die Temperaturabhängigkeit des Nullpunktwiderstands R₀ kann durch schaltungstechnische Maßnahmen oder durch eine Nachbearbeitung der Messergebnisse kompensiert werden. Die Temperaturabhängigkeit des Rauschverhaltens der Diodensensoren kann jedoch nicht kompensiert werden. Insbesondere da herkömmliche Diodensensoren eine nennenswerte Masse und damit eine nennenswerte thermische Kapazität aufweisen, ist es bislang nicht möglich, diese in ihrer Temperatur zu stabilisieren, ohne einen nennenswerten Energieverbrauch und gleichzeitig weitere unerwünschte thermische Effekte auszulösen.

Fig. 1 zeigt ein beispielhaftes Leistungsmessgerät. Ein Leistungsdetektor 1 ist mit einem Signaleingang 6 verbunden. Weiterhin ist der Leistungsdetektor 1 mit einem Chopper (Zerhacker) 2 verbunden. Bei dem Leistungsdetektor handelt es sich um einen Hochfrequenz-Detektor. Der Chopper 2 wiederum ist mit einem Verstärker 3 verbunden. Der Verstärker 3 ist weiterhin mit einem Analog-Digital-Wandler 4 verbunden, welcher weiterhin mit einem digitalen Signalprozessor 5 verbunden ist.

Ein zu vermessendes Hochfrequenz-Signal wird dem Leistungsdetektor 1 mittels des Signaleingangs 6 zugeführt. Der Leistungsdetektor 1 setzt das Hochfrequenz-Signal in ein Signal um, welches die Leistung des Hochfrequenz-Signals anzeigt. Hierzu quadriert der Leistungsdetektor 1 das Hochfrequenz-Signal. Der Leistungsdetektor 1 beinhaltet dabei vorzugsweise zumindest eine Detektor-Diode, deren exponentielle Kennlinie zur Quadrierung des Hochfrequenz-Signals herangezogen wird.

Das Ausgangssignal des Leistungsdetektors 1 wird dem Chopper 2 zugeführt. Dieser multipliziert das Signal abwechselnd mit +1 und -1 und kompensiert so Offsets (Gleichspannungsabweichungen) des nachfolgenden Verstärkers 3. Das resultierende Signal des Zerhackers 2 wird dem Verstärker 3 zugeführt, welcher es verstärkt und dem Analog-Digital-Wandler 4 zuführt. Der Analog-Digital-Wandler 4 digitalisiert das Signal und führt das resultierende digitale Signal dem digitalen Signalprozessor 5 zu. Der digitale Signalprozessor 5 führt eine Nachverarbeitung mit Synchrondemodulation des Signals durch. Im Falle eines herkömmlichen Leistungsmessgeräts führt der digitale Signalprozessor 5 beispielsweise die Temperaturkompensation durch.

Bei einem erfindungsgemäßen Leistungsmessgerät ist nun die Temperatur des Leistungsdetektors 1 durch in dieser Figur nicht dargestellte Mittel konstant gehalten. D.h. es ergibt sich keine Temperaturdrift der Ausgangsspannung. Das Rausch-Verhalten ist auch konstant. Ebenso ist der Nullpunktwiderstand R₀ der Detektordioden innerhalb des Leistungsdetektors 1 konstant. Es ergibt sich somit ein deutlich genaueres Messergebnis als bei einem herkömmlichen Leistungsmessgerät.

Aufgrund der konstanten Temperatur des Leistungsdetektors und damit der Detektordioden kann somit ein Nullpunktwiderstand R₀ gewählt werden, welcher lediglich von dem Abschlusswiderstand der übrigen Schaltung abhängig ist, d.h. der Nullpunktwiderstand R₀ kann sehr viel niedriger gewählt werden, als bei herkömmlichen Detektordioden, deren Temperatur nicht konstant gehalten wird. Bei einem Abschlusswiderstand von 50Ω kann so z.B. ein R₀ von 500Ω gewählt werden. Es ergibt sich somit ein minimales Rauschen. Insbesondere bei Breitband-Diodensensoren ergibt sich der Vorteil, dass bei konstanter Temperatur der Detektordioden eine Charakterisierung über verschiedene Temperaturbereiche entfallen kann. Auch die nachgeschaltete Kompensation kann entfallen.

In den folgenden Fig. 2 - 6 werden Ausführungsbeispiele des erfindungsgemäßen Leistungsmessgeräts gezeigt. Dabei werden lediglich die enthaltenen Leistungsdetektoren dargestellt. Der übrige Aufbau entspricht dem Aufbau des exemplarischen Leistungsmessgeräts aus Fig. 1.

Fig. 2 zeigt ein erstes Ausführungsbeispiel des erfindungsgemäßen Leistungsmessgeräts. Ein metallisches Gehäuse 14 weist eine Aussparung 16 auf. Die Aussparung 16 ist dabei derart dimensioniert, dass der Leistungsdetektor 12 vollständig von der Ausnehmung 16 aufgenommen werden kann. Bei dem hier dargestellten Leistungsdetektor 12 handelt es sich um eine integrierte Schaltung auf einem monolithischen Mikrochip.

Bisherige Leistungsdetektoren waren auf Leiterplatten oder auf Keramiksubstrat aufgebracht. Insbesondere solche Keramiksubstrate weisen aufgrund ihrer Dicke eine nennenswerte thermische Leitfähigkeit auf. Das Einkleben oder Einklemmen in ein Gehäuse führt zu einer intensiven thermischen Kopplung.

In der Aussparung 16 ist ein Peltier-Element 11 verbunden mit dem metallischen Gehäuse 14 angeordnet. Es steht in gutem thermischem Kontakt zu dem Gehäuse 14. Nur die erste Seite des Peltier-Elements 11 ist mit dem Gehäuse 14 verbunden. Auf der zweiten Seite des Peltier-Elements 11 ist der Leistungsdetektor 12 angeordnet. Dieser steht ebenfalls in gutem thermischem Kontakt zu dem Peltier-Element 11. Bei dem Peltier-Element 11 handelt es sich um eine Temperierungsvorrichtung 15. Der Begriff Temperierungsvorrichtung bezeichnet hier lediglich eine Wärme-/Kälte-Quelle. Seitlich zwischen dem Leistungsdetektor 12 und dem metallischen Gehäuse 14 befindet sich ein luftgefüllter Hohlraum, welcher eine schlechte thermische Kopplung des Leistungsdetektors 12 zu dem Gehäuse 14 sicherstellt.

Der erfindungsgemäße Leistungsdetektor 12 ist vollständig auf einem monolithischen Mikrochip integriert. Dieser Mikrochip weist eine sehr geringe Größe von beispielsweise 1 mm x 1mm x ca. 100 µm auf. Es wird eine sehr geringe thermische Kapazität aufgrund einer sehr geringen Masse erreicht.

Dem Leistungsdetektor 12 wird mittels einer Leitung 13 auf einem bevorzugt flexiblen Kunststoffsubstrat 34 das zu vermessende Hochfrequenz-Signal zugeführt. Die Koplanarleitung 13 verbindet damit auf der Oberfläche des Leistungsdetektors 12 angebrachte leitfähige Flächen, welche hier nicht dargestellt sind, mit beispielsweise auf der Oberseite des metallischen Gehäuses 14 elektrisch isoliert angebrachten weiteren Schaltungselementen. Die Leitung 13 ist dabei an der Unterseite des Substrats 34 angebracht. D.h. die Leitung 13 ist auf der dem Leistungsdetektor zugewandten Seite des Substrats 34 angebracht. Die Leitung 13 ist gegenüber dem metallischen Gehäuse 14 isoliert. Sowohl die leitfähigen Flächen auf der Oberseite des Leistungsdetektors 12 wie auch die weiteren Schaltelemente auf der Oberseite des metallischen Gehäuses 14 sind hier nicht dargestellt.

Der Leistungsdetektor 12 ist weiterhin über Bond-Drähte 10 mit weiteren isoliert beispielsweise auf der Oberseite des Gehäuses 14 angeordneten, hier nicht dargestellten, Schaltungselementen verbunden. Über die Bond-Drähte 10 wird vorteilhafterweise das Ausgangssignal des Leistungsdetektors 12 übertragen.

Der Leistungsdetektor 12 weist lediglich eine geringe Masse und somit eine geringe thermische Kapazität auf. Der Hohlraum zwischen der Ausnehmung 16 und dem Leistungsdetektor 12 sorgt für eine schlechte thermische Kopplung des Leistungsdetektors 12 an das metallische Gehäuse 14. Die Leitung 13 ist dabei vorzugsweise eine Koplanarleitung. Alternativ kann sie jedoch auch z.B. eine Streifenleitung (Micro-Strip-Leitung) oder eine Schlitzleitung oder eine Flossenleitung sein. Das Substrat 34 ist vorzugsweise flexibel. Alternativ kann es jedoch auch starr sein. Das Substrat weist einen sehr kleinen Querschnitt und eine geringe thermische Leitfähigkeit auf. Es ergibt sich somit auch durch die Leitung 13 und das Substrat 34 eine geringe thermische Kopplung des Leistungsdetektors 12 an das metallische Gehäuse 14. Auch die Bonddrähte 10 verfügen über einen sehr geringen Durchmesser. Auch diese tragen somit nur sehr wenig zu einer thermischen Leitfähigkeit zwischen dem Leistungsdetektor 12 und dem Gehäuses 14 bei.

Das Peltier-Element 11 kann durch Anlegen einer Gleichspannung dazu veranlasst werden, eine kalte und eine heiße Seite auszubilden. D.h. durch Anlegen einer geregelten Betriebsspannung an das Peltier-Element 11 kann die Temperatur des Leistungsdetektors 12 gegenüber dem metallischen Gehäuse 14 verändert werden. Da die thermische Kapazität des metallischen Gehäuses weit größer ist als die thermische Kapazität des Leistungsdetektors 12, spielt die thermische Kapazität des metallischen Gehäuses 14 für die Funktion des Peltier-Elements 11 keine Rolle.

Der Leistungsdetektor 12 beinhaltet neben der zumindest einen Detektor-Diode zusätzlich vorteilhafterweise eine Temperatur-Mess-Schaltung und eine Steuerschaltung für die Temperierungsvorrichtung 15. D.h. die Temperatur-Mess-Schaltung des Leistungsdetektors 12 misst z.B. mittels eines integrierten temperaturabhängigen Widerstands die Temperatur des Leistungsdetektors 12. Alternativ kann die Steuerschaltung auch außerhalb angebracht sein. Die Steuerschaltung für die Temperierungsvorrichtung 15 steuert ausgehend von der gemessenen Temperatur des Leistungsdetektors 12 die Temperierungsvorrichtung derart, dass die Temperatur des Leistungsdetektors 12 einen konstanten Wert annimmt.

Vorteilhafterweise wird der Leistungsdetektor auf einer Temperatur oberhalb der zulässigen maximalen Umgebungstemperatur des Leistungsmessgeräts gehalten. Es ist so unabhängig von der tatsächlichen Umgebungstemperatur lediglich notwendig, den Leistungsdetektor 12 zu heizen. Eine Kühlung des Leistungsdetektors 12 ist in diesem Fall nicht notwendig. Dies ist vorteilhaft, da Peltier-Elemente einen sehr hohen Wirkungsgrad aufweisen, wenn sie zum Heizen eingesetzt werden. Gleichzeitig weisen sie einen schlechteren Wirkungsgrad auf, wenn sie zum Kühlen eingesetzt werden.

Der Leistungsdetektor 12 kann zusätzlich integriert auf dem Mikrochip bereits erste Verstärkerschaltungen und weitere Verarbeitungsschaltungen beinhalten.

In Fig. 3 wird ein zweites Ausführungsbeispiel des erfindungsgemäßen Leistungsmessgeräts gezeigt. Auch hier wird lediglich der Leistungsdetektor 12 in seiner Einbausituation dargestellt. Das hier dargestellte Ausführungsbeispiel entspricht weitgehend dem in Fig. 2 dargestellten Ausführungsbeispiel. Die Temperierungsvorrichtung 25 entspricht hier der Temperierungsvorrichtung 15 aus Fig. 2. Die Temperierungsvorrichtung 25 weist jedoch statt des Peltier-Elements 11 aus Fig. 2 ein Isolationselement 20 und ein Heizelement 21 auf. Das Isolationselement 20 ist zwischen dem metallischen Gehäuse 14 und dem Heizelement 21 angeordnet. Es isoliert das Heizelement 21 thermisch von dem metallischen Gehäuse 14. Der Leistungsdetektor 12 steht in gutem thermischem Kontakt mit dem Heizelement 21. Aufgrund des Isolationselements 20 steht der Leistungsdetektor 12 in schlechtem thermischem Kontakt zu dem metallischen Gehäuse 14. Im Übrigen entspricht die Funktion der anhand von Fig. 2 dargestellten Funktion. Die hier nicht dargestellte Steuerschaltung steuert statt des Peltier-Elements hier das Heizelement 21 an.

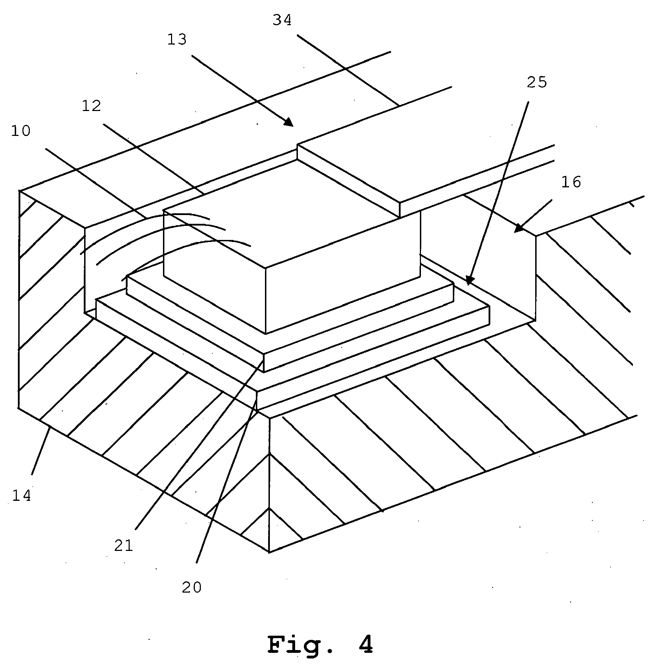

In Fig. 4 wird eine alternative Ansicht des in Fig. 3 gezeigten zweiten Ausführungsbeispiels des erfindungsgemäßen Leistungsmessgeräts gezeigt. Die schraffierten Flächen entsprechen dabei Schnittebenen. D.h. die Ausnehmung 16 umgibt den Leistungsdetektor 12 auf fünf von sechs Seiten.

Statt eines Peltier-Elements 11 oder eines Heizelements 21 kann ebenfalls ein temperaturabhängiger Widerstand oder ein Thermistor eingesetzt werden. In diesem Fall ist keine Temperatur-Mess-Schaltung 12 notwendig. Diese Komponenten benötigen lediglich eine konstante Spannungsversorgung, um eine konstante Temperatur einzustellen. Der Aufbau entspricht dann dem Aufbau aus Fig. 3, wobei das Heizelement 21 durch den temperaturabhängigen Widerstand oder den Thermistor ersetzt wird.

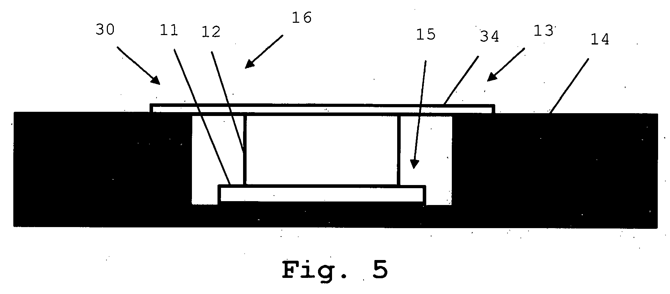

Fig. 5 zeigt ein drittes Ausführungsbeispiel des erfindungsgemäßen Leistungsmessgeräts. Hier überdeckt das Kunststoffsubstrat 30 die gesamte Ausnehmung 16. D.h. zwischen dem Rand des Leistungsdetektors 12 und dem Rand des metallischen Gehäuses 14 verbleibt ein Spalt, welcher auf allen vier Seiten von dem Substrat 30 abgedeckt ist. Dies sorgt für eine höhere mechanische Stabilität des Kunststoffsubstrats 30 wie auch für eine gleichmäßigere Temperaturverteilung auf dem Leistungsdetektor 12.

Vorteilhafterweise beinhaltet das Kunststoffsubstrat 34 neben der ersten Leitung 13, welche das Hochfrequenz-Signal dem Leistungsdetektor 12 zuführt, eine zweite Leitung 30. Die zweite Leitung 30 überträgt das Ausgangssignal des Leistungsdetektors 12 an weitere außerhalb des Leistungsdetektors 12 angeordnete Schaltelemente. Durch die Ausgestaltung der ersten Leitung 13 und der zweiten Leitung 30 auf dem gemeinsamen Kunststoffsubstrat 34 wird eine Reduktion des Herstellungsaufwands erreicht, da die zusätzliche Verarbeitung von Bonddrähten 10 nicht länger notwendig ist. Es ist aber auch möglich, zwei getrennte Substrate für die beiden Leitungen vorzusehen.

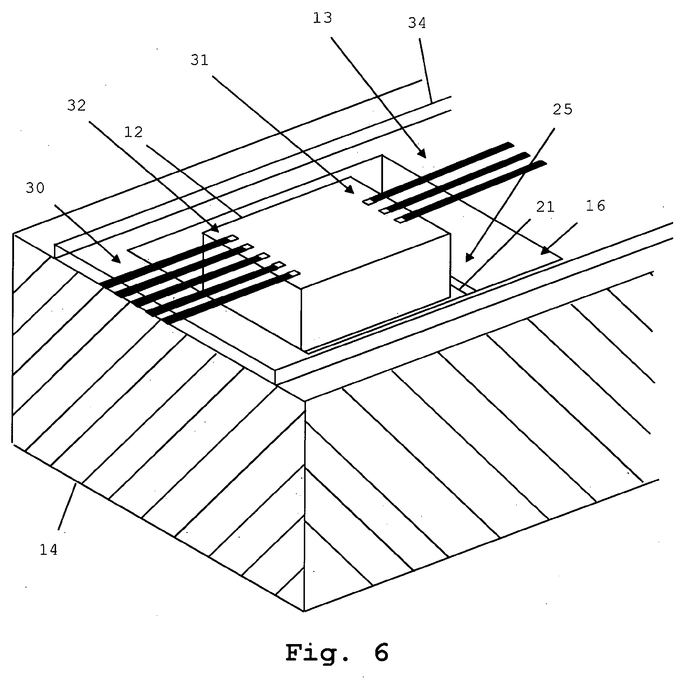

Fig. 6 zeigt das dritte Ausführungsbeispiel in einer alternativen Ansicht. Der Übersichtlichkeit halber ist das Kunststoffsubstrat 34 hier transparent dargestellt. Die Schnittebenen des metallischen Gehäuses 14 befinden sich hier weiter außen als bei Fig. 4. D.h. es sind alle vier Begrenzungen der Aussparung 16 in dem metallischen Gehäuse 14 sichtbar. Deutlich zu erkennen ist hier, dass das Kunststoffsubtrat 34 die Ausnehmung 16 in dem metallischen Gehäuse 14 vollständig abdeckt. An der Unterseite des Kunststoffsubstrats 34, d.h. an der dem Leistungsdetektor 12 zugewandten Seite des Kunststoffsubstrats 34, sind die erste Leitung 13 und die zweite Leitung 30 angebracht. Die erste Leitung 13 kontaktiert dabei erste Anschlussstellen 31 auf der dem Kunststoffsubstrat 34 zugewandten Seite des Leistungsdetektors 12. Die erste Leitung 13 ist dabei als Koplanarleitung, als Streifenleitung oder als Schlitzleitung ausgeführt. Je nach verwendeter Leitungsart erstreckt sich die Leitung ebenfalls auf die Oberseite des Kunststoffsubstrats 34.

Die zweite Leitung 30 steht mit Anschlussstellen 32 auf der Oberseite des Chips, d.h. auf der dem Kunststoffsubstrat 34 zugewandten Seite des Leistungsdetektors 12, in Verbindung. Je nach verwendetem Leitungstyp kann sich auch die zweite Leitung 30 auf die Oberseite des Kunststoffsubstrats 34 erstrecken. Es ist auch denkbar, die zweite Leitung 30 mehradrig auszuführen. D.h. über die zweite Leitung 30 können mehr als ein Signal abgeführt werden. Alternativ ist auch eine Zuführung von Signalen über die zweite Leitung 30 möglich. So könnte z.B. die Steuerspannung der Temperierungsvorrichtung 25 über die zweite Leitung 30 übertragen werden.

In einer alternativen Ausgestaltung ist nicht die gesamte Aussparung 16 des metallischen Gehäuses 14 von dem Kunststoffsubstrat 34 abgedeckt, sondern lediglich die beiden Seiten, welche die erste Leitung 13 und die zweite Leitung 30 beinhalten. D.h. auf den beiden anderen Seiten verbleibt ein Spalt zwischen dem Kunststoffsubstrat 34 und der Aussparung 16.

In einer weiteren alternativen Ausgestaltung können weitere Leitungen von dem Leistungsdetektor 12 abgehen. Diese sind dann ebenfalls auf dem Kunststoffsubstrat 34 angeordnet. So könnten beispielsweise Leitungen in alle vier Richtungen von dem Leistungsdetektor 12 wegführen.

Die Erfindung ist nicht auf das dargestellte Ausführungsbeispiel beschränkt. Es ist ebenso denkbar, mehr als eine Detektordiode auf dem Leistungsdetektor unterzubringen. Statt einer Koplanarleitung kann auch eine andere Streifenleitungstechnik, z.B. eine Stripline Technik oder eine Triplate Technik verwendet werden.

## Patentansprüche

1. Leistungsmessgerät mit einem Leistungsdetektor (12) und einer Temperierungsvorrichtung (15, 25),
wobei der Leistungsdetektor (12) als integrierte Schaltung auf einem monolithischen Chip integriert ist und ein Hochfrequenz-Messsignal in ein Signal, welches die Leistung des Hochfrequenz-Messsignals anzeigt, umsetzt, wobei das Leistungsmessgerät über einen Signaleingang verfügt,
wobei
der Signaleingang mittels einer ersten Leitung (13) auf einem Kunststoffsubstrat (34) mit dem Leistungsdetektor (12) verbunden ist,
das Hochfrequenz-Messsignal mittels der ersten Leitung (13) vom Signaleingang zum Leistungsdetektor (12) geführt ist, und
das Kunststoffsubstrat (34) mit einer Dicke von 10 µm - 100 µm ausgebildet ist.

2. Leistungsmessgerät nach Anspruch 1,
**dadurch gekennzeichnet,**
**dass** die Temperierungsvorrichtung (15, 25) außerhalb des monolithischen Chips auf einer der integrierten Schaltung abgewandten Seite des monolithischen Chips angeordnet ist.

3. Leistungsmessgerät nach Anspruch 1 oder 2,
**dadurch gekennzeichnet,**
**dass** der Leistungsdetektor (12) über eine gegenüber dem übrigen Leistungsmessgerät sehr geringe Wärmekapazität verfügt.

4. Leistungsmessgerät nach einem der Ansprüche 1 bis 3,
**dadurch gekennzeichnet,**
**dass** die integrierte Schaltung zumindest eine Detektordiode beinhaltet.

5. Leistungsmessgerät nach einem der Ansprüche 1 bis 4,
**dadurch gekennzeichnet,**
**dass** die integrierte Schaltung eine Verstärkerschaltung beinhaltet.

6. Leistungsmessgerät nach einem der Ansprüche 1 bis 5,
**dadurch gekennzeichnet,**
**dass** die erste Leitung (13) eine Koplanarleitung oder eine Schlitzleitung oder eine Streifenleitung oder Flossenleitung ist.

7. Leistungsmessgerät nach einem der Ansprüche 1 bis 6,
**dadurch gekennzeichnet,**
**dass** die Temperierungsvorrichtung (25) ausgebildet ist, um den Leistungsdetektor (12) zu beheizen, und
**dass** die Temperierungsvorrichtung (25) einen ohmschen Heizwiderstand oder einen Thermistor beinhaltet.

8. Leistungsmessgerät nach einem der Ansprüche 1 bis 7,
**dadurch gekennzeichnet,**
**dass** die Temperierungsvorrichtung (15) ausgebildet ist, um den Leistungsdetektor (12) zu heizen und zu kühlen, und dass die Temperierungsvorrichtung (15) ein Peltierelement beinhaltet.

9. Leistungsmessgerät nach einem der Ansprüche 1 bis 6,
**dadurch gekennzeichnet,**
**dass** der Leistungsdetektor (12) thermisch weitgehend von dem übrigen Leistungsmessgerät entkoppelt ist.

10. Leistungsmessgerät nach einem der Ansprüche 1 bis 9,
**dadurch gekennzeichnet,**
**dass** das Leistungsmessgerät weiterhin über ein metallisches Gehäuse (14) verfügt,
**dass** der Leistungsdetektor (12) in eine Ausnehmung (16) des metallischen Gehäuses (14) eingebettet ist, und
**dass** der Leistungsdetektor (12) thermisch von dem metallischen Gehäuse (14) isoliert ist.

11. Leistungsmessgerät nach Anspruch 10,
**dadurch gekennzeichnet,**
**dass** das Kunststoffsubstrat (34) der ersten Leitung (13) die gesamte Ausnehmung (16) des metallischen Gehäuses (14) abdeckt.

12. Leistungsmessgerät nach einem der Ansprüche 1 bis 11,
**dadurch gekennzeichnet,**
**dass** die erste Leitung (13) mit ersten Anschlussstellen (31) auf der der integrierten Schaltung zugewandten Seite des monolithischen Chips verbunden ist.

13. Leistungsmessgerät nach einem der Ansprüche 1 bis 12,
**dadurch gekennzeichnet,**
**dass** das Kunststoffsubstrat oder ein weiteres Kunststoffsubstrat eine zweite Leitung (30) trägt, und dass die zweite Leitung (30) ausgebildet ist, um ein Ausgangssignal des Leistungsdetektors (12) zu übertragen.

14. Leistungsmessgerät nach Anspruch 13,
**dadurch gekennzeichnet,**
**dass** die zweite Leitung (30) mit zweiten Anschlussstellen (32) auf der der integrierten Schaltung zugewandten Seite des monolithischen Chips verbunden ist.

15. Leistungsmessgerät nach einem der Ansprüche 1 bis 14,
**dadurch gekennzeichnet,**
dass- das Kunststoffsubstrat (34) ein flexibles Kunststoffsubstrat (34) ist.

## Claims

1. Power measuring apparatus with a power detector (12) and a conditioning device (15, 25),
wherein the power detector (12) is incorporated as an integrated circuit on a monolithic chip and converts a high-frequency measurement signal into a signal which indicates the power of the high-frequency measurement signal,
wherein the power measuring apparatus has a signal input, wherein the signal input is connected by means of a first line (13) on a plastic substrate (34) with the power detector (12),
wherein the high-frequency measurement signal is carried by means of the first line (13) from the signal input to the power detector (12), and
wherein the plastic substrate (34) is embodied with a thickness of from 10 µm to 100 µm.

2. Power measuring apparatus according to claim 1,
**characterised in that**
the conditioning device (15, 25) is arranged outside the monolithic chip on a side of the monolithic chip facing away from the integrated circuit.

3. Power measuring apparatus according to claim 1 or 2,
**characterised in that**
the power detector (12) has a very low thermal capacity compared to the remainder of the power measuring apparatus.

4. Power measuring apparatus according to one of claims 1 to 3,
**characterised in that**
the integrated circuit comprises at least one detector diode.

5. Power measuring apparatus according to one of claims 1 to 4,
**characterised in that**
the integrated circuit comprises an amplifier circuit.

6. Power measuring apparatus according to one of claims 1 to 5,
**characterised in that**
the first line (13) is a coplanar line or a slot line or a strip line or a fin line.

7. Power measuring apparatus according to one of claims 1 to 6,
**characterised in that**
the conditioning device (25) is configured to heat the power detector (12), and **in that** the conditioning device (25) comprises an ohmic heating resistance or a thermistor.

8. Power measuring apparatus according one of claims 1 to 7,
**characterised in that**
the conditioning device (15) is configured to heat and to cool the power detector (12), and **in that** the conditioning device (15) comprises a Peltier element.

9. Power measuring apparatus according to one of claims 1 to 6,
**characterised in that**
the power detector (12) is thermally largely decoupled from the remainder of the power measuring apparatus.

10. Power measuring apparatus according to one of claims 1 to 9,
**characterised in that**
the power measuring apparatus also has a metal housing (14), **in that** the power detector (12) is embedded in a recess (16) of the metal housing (14), and
**in that** the power detector (13) is insulated thermally from the metal housing (14).

11. Power measuring apparatus according to claim 10,
**characterised in that**
the plastic substrate (34) of the first line (13) covers the entire recess (16) of the metal housing (14).

12. Power measuring apparatus according to one of claims 1 to 11,
**characterised in that**
the first line (13) is connected with first connection points (31) on the side of the monolithic chip facing towards the integrated circuit.

13. Power measuring apparatus according to one of claims 1 to 12,
**characterised in that**
the plastic substrate or a further plastic substrate carries a second line (30), and **in that** the second line (30) is configured to transmit an output signal of the power detector (12).

14. Power measuring apparatus according to claim 13,
**characterised in that**
the second line (30) is connected with second connection points (32) on the side of the monolithic chip facing towards the integrated circuit.

15. Power measuring apparatus according to one of claims 1 to 14,
**characterised in that**
the plastic substrate (34) is a flexible plastic substrate (34).

## Revendications

1. Appareil de mesure de puissance comportant un détecteur de puissance (12) et un dispositif de mise en température (15, 25),
dans lequel le détecteur de puissance (12) est intégré en tant que circuit intégré sur une puce monolithique et convertit un signal de mesure haute fréquence en un signal, qui indique la puissance du signal de mesure haute fréquence,
dans lequel l'appareil de mesure de puissance comporte une entrée de signal,
dans lequel l'entrée de signal est reliée au détecteur de puissance (12) grâce à une première ligne (13) sur un substrat en matière plastique (34),
dans lequel le signal de mesure haute fréquence est guidé grâce à la première ligne (13) de l'entrée de signal au détecteur de puissance (12), et
dans lequel le substrat en matière plastique (34) est réalisé avec une épaisseur de 10 µm-100 µm.

2. Appareil de mesure de puissance selon la revendication 1, **caractérisé en ce que**
le dispositif de mise en température (15, 25) est disposé à l'extérieur de la puce monolithique sur un côté opposé au circuit intégré de la puce monolithique.

3. Appareil de mesure de puissance selon la revendication 1 ou 2, **caractérisé en ce que**
le détecter de puissance (12) comporte une capacité thermique très faible par rapport au reste de l'appareil de mesure de puissance.

4. Appareil de mesure de puissance selon l'une des revendications 1 à 3, **caractérisé en ce que**
le circuit intégré comporte au moins une diode de détection.

5. Appareil de mesure de puissance selon l'une des revendications 1 à 4, **caractérisé en ce que**
le circuit intégré comporte un circuit amplificateur.

6. Appareil de mesure de puissance selon l'une des revendications 1 à 5, **caractérisé en ce que**
la première ligne (13) est une ligne coplanaire ou une ligne à fentes ou une ligne à rubans ou une ligne à ailettes.

7. Appareil de mesure de puissance selon l'une des revendications 1 à 6, **caractérisé en ce que**
le dispositif de mise en température (25) est réalisé pour chauffer le détecteur de puissance (12), et
**en ce que** le dispositif de mise en température (25) comporte une résistance chauffante ohmique ou un thermistor.

8. Appareil de mesure de puissance selon l'une des revendications 1 à 7, **caractérisé en ce que**
le dispositif de mise en température (15) est réalisé pour chauffer ou refroidir le détecteur de puissance (12), et
**en ce que** le dispositif de mise en température (15) comporte un élément Peltier.

9. Appareil de mesure de puissance selon l'une des revendications 1 à 6, **caractérisé en ce que**
le détecteur de puissance (12) est découplé thermiquement dans une large mesure du reste de l'appareil de mesure de puissance.

10. Appareil de mesure de puissance selon l'une des revendications 1 à 9, **caractérisé en ce que**
l'appareil de mesure de puissance comporte en outre un boîtier métallique (14),
**en ce que** le détecteur de puissance (12) est intégré dans un évidement (16) du boîtier métallique (14), et
**en ce que** le détecteur de puissance (12) est isolé thermiquement du boîtier métallique (14).

11. Appareil de mesure de puissance selon la revendication 10, **caractérisé en ce que**
le substrat en matière plastique (34) de la première ligne (13) recouvre la totalité de l'évidement (16) du boîtier métallique (14).

12. Appareil de mesure de puissance selon l'une des revendications 1 à 11, **caractérisé en ce que**
la première ligne (13) est reliée à des premiers points de connexion (31) sur le côté associé au circuit intégré de la puce monolithique.

13. Appareil de mesure de puissance selon l'une des revendications 1 à 12, **caractérisé en ce que**
le substrat en matière plastique ou un autre substrat en matière plastique supporte une seconde ligne (30), et
**en ce que** la seconde ligne (30) est réalisée pour transmettre un signal de sortie du détecteur de puissance (12).

14. Appareil de mesure de puissance selon la revendication 13, **caractérisé en ce que**
la seconde ligne (30) est reliée à des seconds points de connexion (32) sur le côté associé au circuit intégré de la puce monolithique.

15. Appareil de mesure de puissance selon l'une des revendications 1 à 14, **caractérisé en ce que**
le substrat en matière plastique (34) est un substrat en matière plastique (34) flexible.
